# EUROPEAN PATENT SPECIFICATION

(11) **EP 2 421 349 B1**
(45) Date of publication and mention of the grant of the patent: **07.09.2016**
(21) Application number: 11008439.9
(22) Date of filing: 09.11.2007
(51) Int. Cl.: H05K 7/20, G06F 1/20

(54) **System and method for climate control**
System und Verfahren für Klimatisierung
Système et procédé pour le contrôle climatique

(43) Date of publication of application: 22.02.2012
(62) Divisional of application: 07021813.6
(73) Proprietor: Knürr GmbH, 94424 Arnstorf (DE)
(72) Inventor: Gallmann, Martin, 5436 Würenlos (CH); Honold, Olivier, 8703 Erlenbach (CH); Reiter, Rupert, 84378 Dietersburg (DE)
(74) Representative: Röthinger, Rainer

(56) References cited:
- WO-A2-2006/124240
- US-A1- 2005 187 664
- US-A1- 2006 168 975

## Description

### Field of the Invention

This invention relates to a system and method for climate control. More particularly, this invention relates to a technique for efficiently controlling climate parameters of racks.

### Background

Electronic devices, such as computers and their periphery have become widespread. Where such devices have to be accumulated to form large systems, it has become common to organize the elements in racks. Conventionally, racks of a certain width (e.g. 19 inches) are used and the size of an electronic element is usually given in height units, where one height unit equals 1,75 inches = 44,45 mm. Computer racks of one standard size offer space for up to 42 high units.

Many devices that can be housed inside such racks consume enough electrical power to heat up their surroundings. As there is a limit to the temperatures at which electronic devices may be operated, means for maintaining the temperature inside these devices underneath a critical level must be taken. To this ends, many electronic devices comprise electrical fans which assure cooling of the precious electronic part inside the devices. However, if electronic devices are packed tightly, the cooling effect may not be sufficient using air of room temperature. Inside data centres, where often large numbers of computers and their periphery are hosted in a plurality of racks, it is common to have climate control systems that control the temperature and humidity of the air inside the data centre.

In many data centres, flow of the ambient air through the electronic devices inside the racks and further around the data centre is more or less arbitrary, as the hosted systems (oftentimes legacy systems, the age of which may vary over several decades) are not designed to support an organized flow of air through the data centre. Consequently, the climate control units inside the data centres are often controlled such that it is ensured that the climate conditions inside the data centre do not trespass certain predefined limits at any point throughout the room. Should for instance one of the devices produce a large amount of heat, and its ambient temperature therefore rise, a thus controlled climate control unit, if it detects the "hotspot", would increase its performance for the complete room. While a higher performance of the climate control unit will largely not harm any of the other installed electronic devices, such generalized cooling will generally consume more power than necessary. Document US 2006/0168975 A1 describes a data center including a ventilation system, wherein the air flow is monitored and location-mapped throughout the data center configuration.

Document WO 2006/124240 A2 describes a cold aisle having a pair of baffles disposed on top of the rows.

Document US 2005/0187664 A1 describes a system for detecting air flow in a room by means of movable components.

It is therefore an object of the invention to provide a system for controlling climate inside a rack that is efficient and easy to implement starting from standard components.

### Summary of the Invention

According to one aspect, the invention solves this problem by providing a device for controlling climate parameters according to claim 1.

A system may comprise at least one rack; at least one climate control unit for controlling climate parameters of a medium; a duct for exchanging the medium between the at least one rack and the climate control unit. The rack may be an industry standard rack of 19 inch width. It may have a height of 42 units, where one unit equals 1,75 inches = 44,45 mm. Generally, the rack may also have different dimensions. In one embodiment, each of the racks in the system has the same height, width and depth.

The climate parameters may comprise at least one of a temperature and a humidity. Climate parameters may also comprise a pressure, a level of sound, a composition, a concentration of dust or any other parameter that may influence the climate inside the at least one rack.

The medium is air.

The duct may be situated essentially below the at least one rack. In one embodiment, it is a task of the medium to modify a temperature inside the rack and medium of a lower temperature may be delivered towards the rack from below the rack and medium of a higher temperature may be removed from the rack above the rack. Generally, any other arrangement of the duct with respect to the rack is also possible.

The duct may comprise a lower and an upper plane, the at least one rack being situated on top of the upper plane. In this case, the duct may run between the two layers of a double bottom. A space between the two layers of the double bottom may be any height that will permit a sufficient flow of medium, in one embodiment between 20 and 120 cm, in another embodiment between 40 and 60 cm.

A space between the lower and the upper plane may also comprise provisioning lines connected to the at least one rack. Such provisioning lines may comprise power lines, communication lines in the shape of wire-based or fibre-optics lines and supply- and removal lines for liquids or gases. Any other kind of provisioning lines is also possible. In one embodiment, provisioning lines run inside the duct. In a further embodiment, the duct is identical to the space between the two planes. Where lines pierce the duct, they may be sealed with respect to the duct, to prevent an exchange of medium along the pierce point. Such a sealing may comprise any kind of sealing known in the art. In one embodiment, lines that pierce the duct are sealed using brush strips. While it may not be necessary to ensure a 100 % sealing of the planes, any loss of media through a pierce point may lead to a decrease in efficiency of the system.

The system may also comprise a housing for closing a path along which the medium may circulate between the at least one rack and the climate control unit, the duct forming a portion of the path. The housing may comprise floors, ceilings and walls of a data centre room. The climate control unit may be situated inside the housing. It may be fed by medium from a higher level inside the housing and it may perform climate control on the fed medium and then forward the medium through the duct towards the at least one rack. The climate control unit may also be situated outside the housing. In this case, further ducts may be used to permit exchange of medium between the at least one rack and the climate control unit.

The system may also comprise a conveyor for conveying the medium. The conveyor may be situated at any point along the path along which the medium is exchanged between the climate control unit and the at least one rack.

The conveyor may form a portion of the ducts. In another embodiment, the conveyor may be part of the climate control unit. In still another embodiment, the conveyor may be used to collect air from inside the housing and convey it towards the climate control unit. In a variant, more than one conveyor is situated along the medium circulation path.

The at least one rack may have a supply side for supplying medium to the at least one rack and a removal side opposite the supply side for removing medium from the at least one rack. In yet another embodiment, the supply side and the removal side are not on opposite sides. They may be on different sides of the rack, though. In one embodiment, the rack is roughly block-shaped and comprises a front- and a backside. The front side may be the supply side and the backside may be the removal side for the medium. Orientation of the supply- and removal-sides may be dependent on a preferred direction of movements of medium through the rack. This direction, in turn, may be dependent on the preferences of an object to be held inside the rack, such as electronic parts, i.e. a computer.

The duct may be arranged at one of the supply side and the removal side of the at least one rack such that essentially all of the medium passing through the ducts passes through the at least one rack. In one embodiment, the duct terminates in the vicinity of the rack and shielding means are used to seal the flow of medium from the end of the duct to one of the supply side and the removal side of the at least one rack. Again, it is not required to provide a 100 % sealing between any of the sides of the least one rack and the end of the ducts, but any leak may degrade the efficiency of the system.

The system may comprise a plurality of racks arranged such as to form at least one aisle between them and that for each aisle, one of the supply sides and the removal sides of all racks adjacent to the aisle face towards the aisle. In one embodiment, all racks are block-shaped and have same height, width and depth. The racks may be arranged in two columns spaced apart far enough to permit maintenance access to the items contained inside the racks. All of the supply sides may face the aisle and all of the removal sides may be on those sides of the racks that face away from the aisle. In a different embodiment, all of the removal sides face the aisle and all of the supply sides face away from the aisle.

The duct may connect the aisle with the climate control unit. In one embodiment, the space between two planes of a double bottom inside a data centre room serves as the duct and the upper plane has openings that permit the medium to flow between the duct and the aisle. To increase serviceability of the racks, a grill may serve as a portion of floor that separates the aisle from the duct.

The aisle may comprise a termination element at one of its ends to seal the aisle. In another embodiment, the aisle may have more ends that are not closed by racks but by termination elements. The termination elements may comprise doors to permit servicing personal to enter and leave the aisle. The doors may be of transparent or opaque material. The doors may be sliding doors or swing doors. In one embodiment, the doors are swing doors and open up to 180° to form part of an escape route for servicing personal.

The system comprises at least one cover element sealing the aisle at a top end. The cover element may be transparent to accommodate illumination inside the aisle. The cover element may be spaced apart from the racks by elements that are not permeable for the medium.

The cover element comprises a medium bleeding opening for bleeding medium from or into the aisle. The bleeding opening may comprise a sensor that is used for determining a direction of flow of medium through the bleeding opening. In one embodiment, such a sensor comprises an airscrew which turns in a direction according to the direction of a medium flowing through it. The sensor may also comprise a switch that is attached to a sail which catches some of the media and turns into a direction dependent on a direction of flow of the medium. In another embodiment, properties of the medium on both ends of the bleeding opening are compared. This may for instance be a temperature or a pressure of the medium. Both of the sensors may be located closed to the bleeding opening or spaced apart from it along the path of circulation.

The at least one rack may comprise a plurality of mounting spaces for accommodating payload. The mounting spaces may have a width of 19 inches. Mounting spaces that are not occupied by payload may be sealed towards the aisle. Such unused spaces may also be sealed towards the side of the rack facing away from the aisle. These seals may be removable to permit later installation of payload. The mounting spaces may be sealed with respect to the payload to prevent uncontrolled medium flow through the at least one rack.

The payload situated in one of the mounting spaces may comprise electrically powered equipment. Such equipment may comprise computers, storage systems, processing units, storage units, network elements such as switches, hubs, routers and any other kind of electrical equipment, especially the kind of equipment that can generally be found inside data centrals.

The payload may comprise a private medium conveyor for conveying medium from the supply side to the removal side of the at least one rack. In one embodiment, all payloads inside a rack are arranged such that the supply side of the payload matches the supply side of the rack, and the removal side of the payload matches the removal side of the rack. Furthermore, a plurality of racks may be arranged in one row and all supply sides of all racks face in one direction while all removal sides of all racks face the opposite side of the racks. The payload may also comprise a plurality of private medium conveyors.

The payload may comprise a controller for controlling the private medium conveyor on the basis of payload parameters. Such payload parameters may comprise sensor readings or a determined state of the payload. The payload may also comprise communication means for exchanging information about its internal state and the performance and operation of its private medium conveyor with other devices.

The system may comprise a plurality of sensors and a master control unit connected to each sensor, wherein the master control unit is adapted to control performance of at least one of the conveyor and the climate control unit. The sensors may be positioned in a number of locations along and adjacent to the circulation path of the system. For example, sensors may sample any of the above-explained climate parameters and be situated at different positions inside each payload, inside payload spaces where no payload is installed, on the top and bottom of each rack, on the supply and removal side of each rack, at positions throughout the duct, around various positions near the conveyor, at various positions around the climate control unit and on the flow path between the climate control unit and the rack outside the duct. The master control unit may determine the performance of the conveyor and/or the climate control unit on the basis of these elements. The master control unit may also use information exchanged with payload installed inside any of the at least one racks.

The system may comprise a first sensor that is located close to the bleeding opening. In one variant, the first sensor is located on the aisle side of the bleeding opening. In another embodiment, the first sensor is located on the other side of the bleeding opening.

The system may comprise a second sensor that is located at a distance to the bleeding opening. In one embodiment, the second sensor is located as far away as possible from the rack along the medium circulation path, but before the medium enters the climate control unit. In another embodiment, the second sensor is located somewhere along the medium path between the bleeding hole and the climate control unit. In yet another embodiment, the second temperature sensor may be located somewhere along the medium path between the climate control unit and the end of the duct, close to the rack.

The plurality of sensors may comprise temperature sensors. In addition to the variety of climate sensors explained above, it may also comprise power consumption sensor, radiation sensors, current- and voltage-sensors and any other kind of sensors that may sample useful information to control operation of the climate control unit and the conveyor, respectively.

The climate control unit may comprise a slave control unit connected to the master control unit. The slave control unit may be part of the climate control unit and be operable through a user interface located at the climate control unit or via a remote operation unit. The slave control unit may be adapted to communicate with the master control unit and it may be adapted to accept commands from the master control units.

The slave control units may be adapted to sustain operation of the climate control unit in case communication with the master control unit is interrupted. To this ends, the slave control units may control a mode of operation of the climate control units that is no longer dependent on the readouts of sensors to which no communication exists. In this way, operation of a data centre may be ensured even in the case of a failed master controlled unit. The climate control unit may be adapted to be connected to at least two different power supplies. The power supplies may be independent from each other. At least one of the power supplies may be interruption free. This may comprise a battery-based solution. Each of the power supplies may also be backed-up by an electric generator which starts operation if a connection to an external supply for electricity fails.

According to another aspect of the invention, the problem is solved through a method for controlling at least one climate parameter according to claim 15.

The method may comprise the steps of maintaining, at a location before the medium enters the rack, the at least one climate parameter of the medium at a predetermined value, advancing, by a conveyor, the current of medium towards a medium supply side of the rack, determining if a turnover of medium through the rack differs from a turnover of medium through the conveyor, controlling performance of the conveyor in correspondence to a determined turnover difference. The method may be carried out via a system as described above.

The at least one climate parameter may comprise a temperature. It may also comprise a humidity or a composition of the medium.

The turnover difference may be determined on the basis of a flow of medium through a duct that connects the supply side of the rack with a medium removal side of the rack. This duct may be identical to the bleeding hole described above. The duct may be small in comparison to the size of the rack. In one embodiment, the duct may be at a position close to the rack, but as far away as possible from the conveyor. The duct may be a simple hole in an isolation material, or it may a tube of any sort.

A performance of the conveyor may be increased if a medium flow from a removal side to the supply side is determined. Similarly, performance of the conveyor may be decreased if said medium flow is no longer detected. Correspondence between a detected medium flow through the duct and a change in performance of the conveyor may be done with a standard regulation module, such as a P, I, D, PI, PD, ID or PID regulation module.

In another embodiment, a medium flow of a certain magnitude is considered to correspond to a turnover of medium through the rack that does not differ from a turnover of medium through the conveyor. This "zero" flow may be defined in any direction through the duct.

The climate parameter may be a temperature and a flow direction through the duct may be determined on the basis of a difference between a temperature of the medium inside the duct and a temperature of the medium at the location before the current enters the rack. A certain difference in temperature may be indicative of a turnover of medium through the rack that is equal to the turnover of medium to the conveyor. In correspondence to a change in temperature difference between the two points, performance of the conveyor may be controlled.

### Description of the Drawings

Preferred embodiments of the invention will now be discussed with reference to the figures, in which:
Fig. 1: shows a rack layout without separation of cold and warm aisles;
Fig. 2: shows another rack layout with separation of cold and warm aisles;
Fig. 3: shows a rack layout embodiment according to the invention;

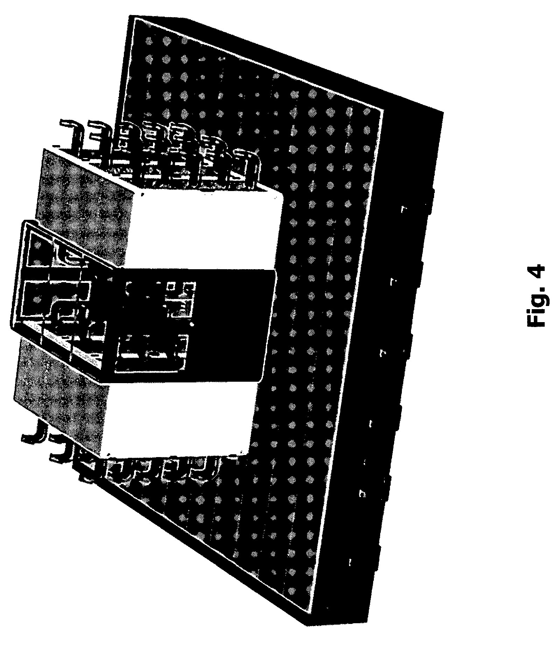

Fig. 4: shows a perspective view of another rack layout embodiment according to the invention;
Fig. 5: shows an overview of a data centre with one rack layout embodiment according to the invention;

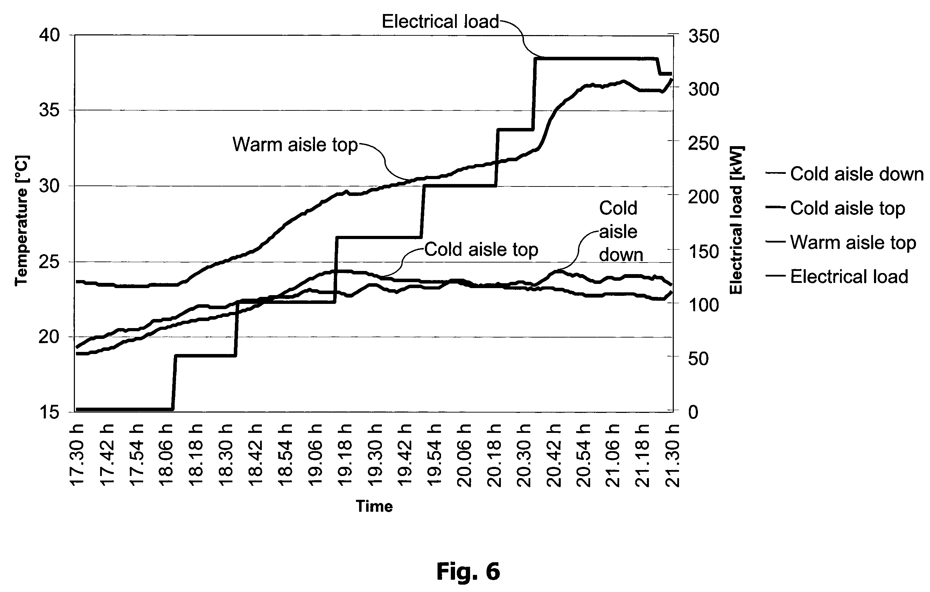

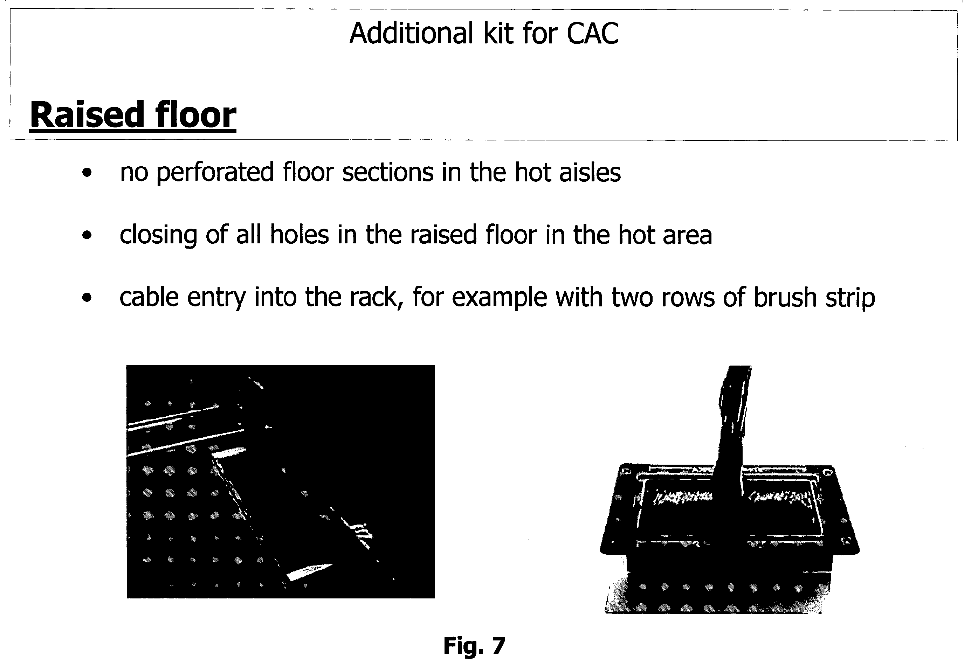

Fig. 6: shows results of a load test of data centre;
Fig. 7:
   shows details for sealing an aisle;

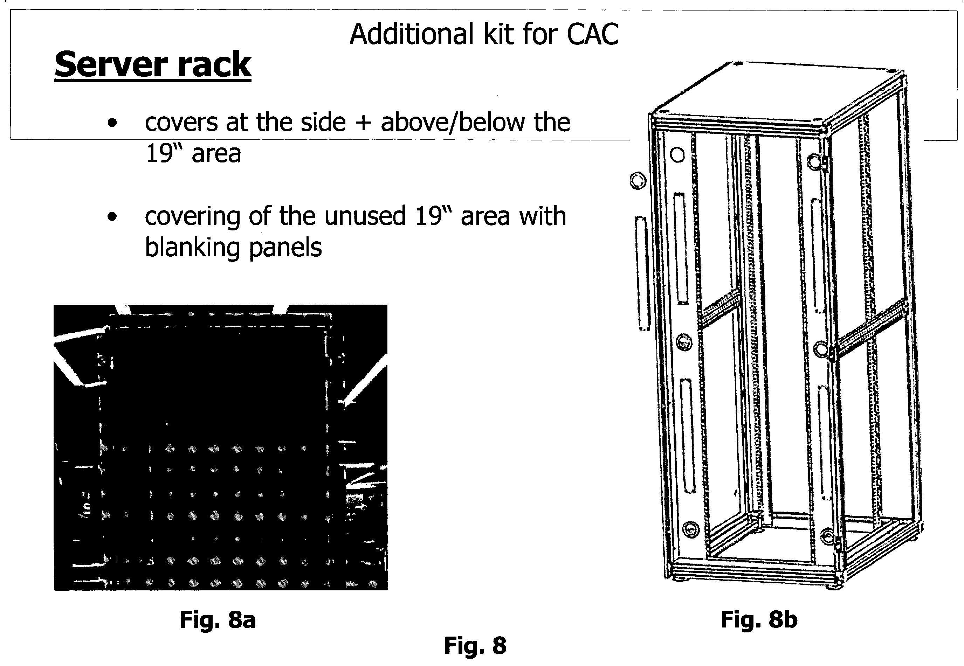

Fig. 8a and 8b: show details of sealing a server rack;

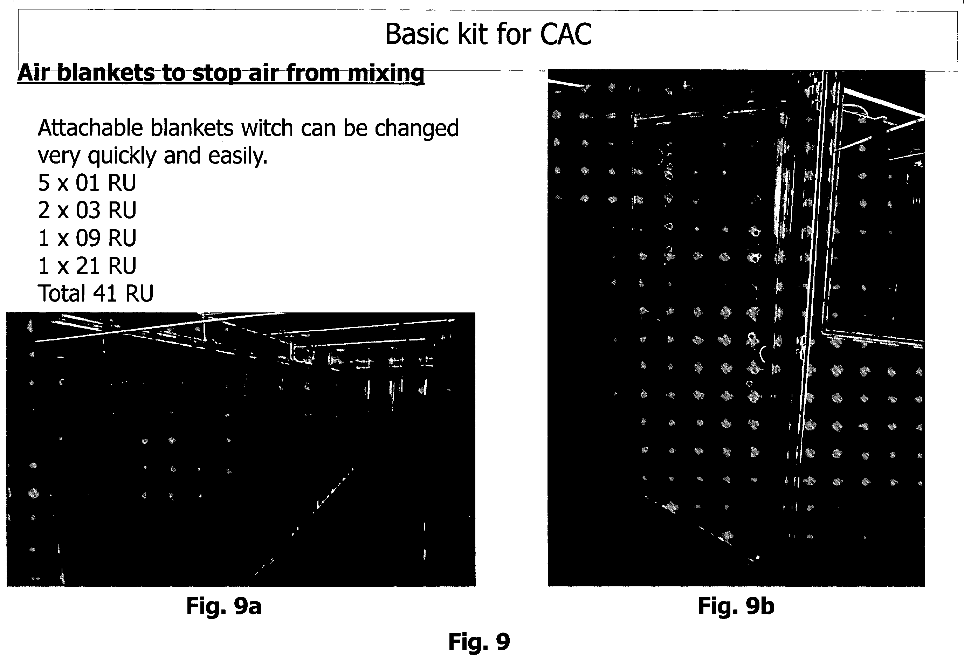

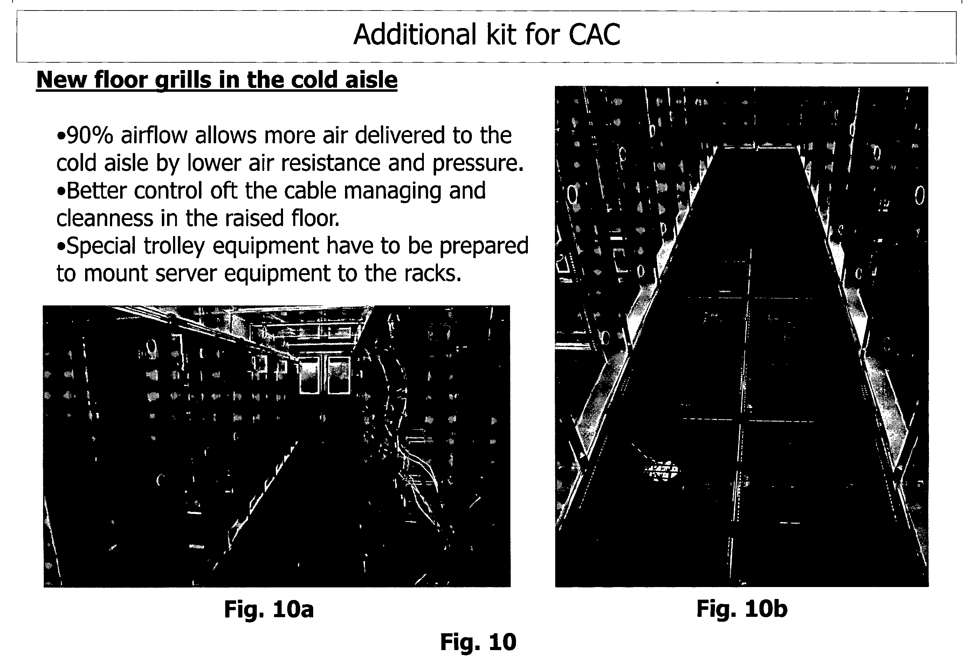

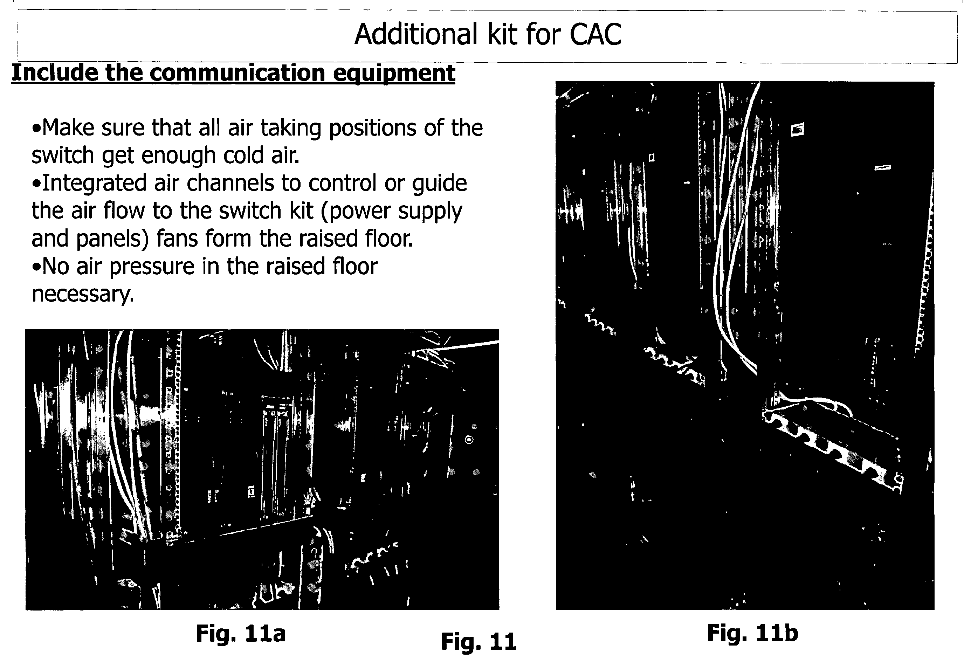

Figs. 9 to 11: show various kits for the CAC.

### Detailed Description

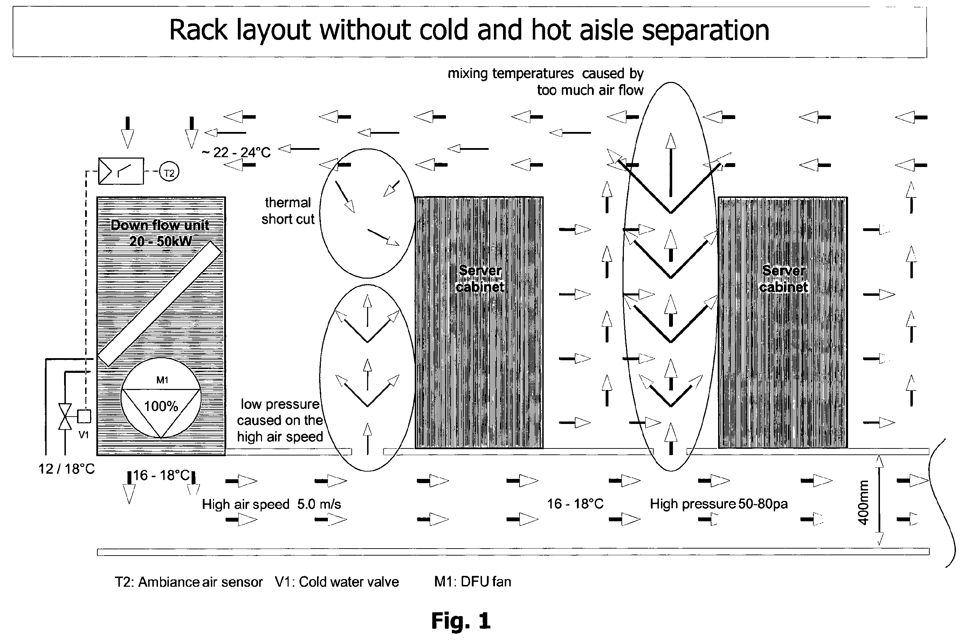

Fig. 1 shows a rack layout without cold and hot aisle separation. This kind of rack layout is common in data centres that host legacy systems that were not specially built for supporting a ventilation path inside a data centre. As can be seen in the tall ellipsis to the right hand side of the figure, cold air from below the server cabinets and heated air that is ejected from the server cabinets get mixed, which reduces the efficiency of the data centre air conditioning.

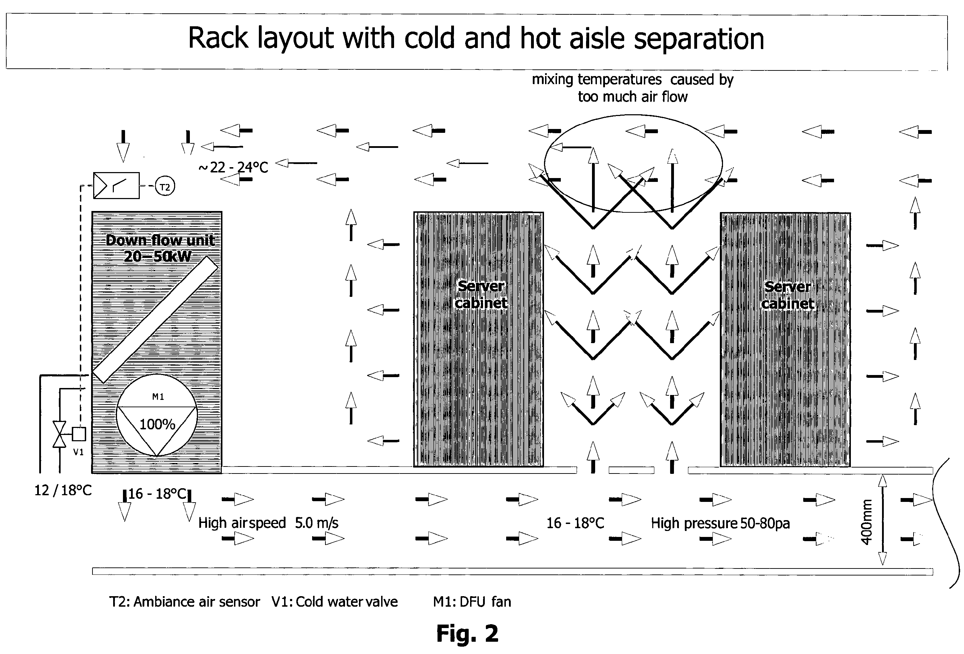

Fig. 2 shows another variant of rack layout inside a data centre with cold and hot aisle separation. Indicated by an ellipsis is a zone where cold and heated airflows mix and thus degrade efficiency of the cooling system.

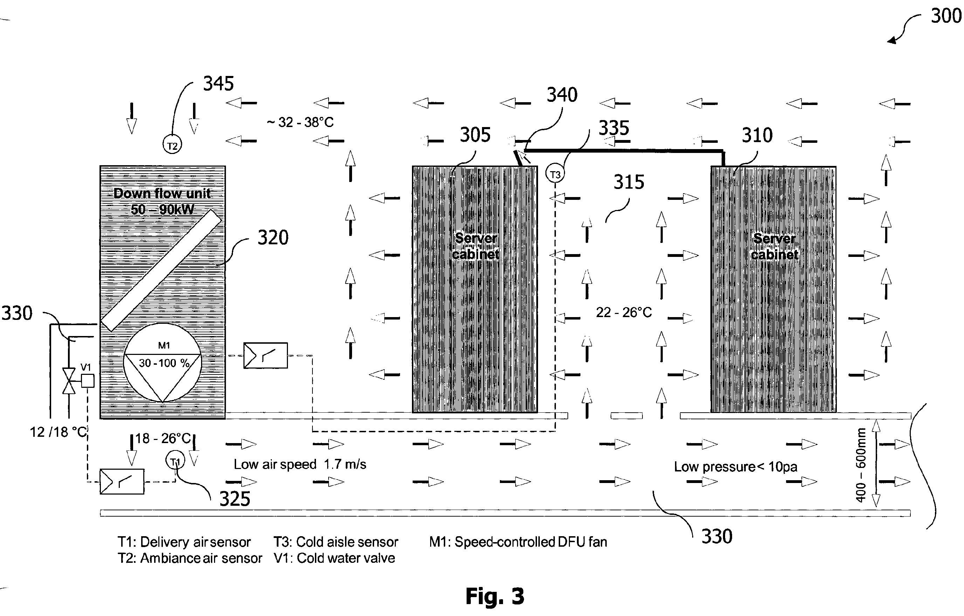

Fig. 3 shows a system 300 for maintaining a predetermined temperature inside server cabinets 305 and 310. The sever cabinets 305 and 310 are located on both sides of an aisle 315. Cool air rises from below towards the server cabinets 305, 310 which have their cooling air supply sides facing towards the aisle 315. The air is heated while it passes through the server cabinets 305 and 310. Outside the server cabinets 305 and 310, the warmed air rises towards the ceiling and is eventually sucked in by a climate control unit 320. The climate control unit 320 cools the sucked- in air and supplies it to a duct that leads back to the aisle 315.

In the displayed embodiment, the climate control unit 320 is a so-called chiller, which is attached to a cold water supply and warm water removal tubes. The supply-side water may have a temperature around 5 to 15°C, and in one embodiment the temperature lies between 11 and 13°C. The water on the removal side may have a temperature that is higher than the temperature at the supply side. Specifically, the water temperature at the removal side may be between 12 and 22°C, and in one embodiment around 16 to 19°C.

A temperature sensor 325 senses the temperature of the air that is output by the climate control unit 320. Depending on the determined temperature a valve 330 is operated, which controls flow of cooling water through the climate control unit 320. A regulation may be used that keeps the temperature of the air output by the climate control unit 320 at a temperature between 15 and 30°C. More particularly, the output air temperature may be between 18 and 26°C. In one embodiment, the temperature of the output air may be 20°C.

The climate control unit 320 also comprises a conveyor (not displayed) for propelling cool air into a duct 325. During normal operation, the conveyor may propel the cooling air at an airspeed of 1 to 3 m per second. In one embodiment, the airspeed may be between 1,5 and 2,2 m per second. Speed of the air is related to a height of the duct 330, along which the cold air is propelled from the climate control unit 320 towards the aisle 315. Height of the duct may be between 150 and 800 mm. In one embodiment, the height may be between 300 and 600 mm. In yet another embodiment, the height may be between 400 and 500 mm. Depending on the airspeed and the height of the duct 330, air pressure inside the duct 330 may be low, for instance no more than 10 Pascal over the air pressure inside the data centre (not displayed).

At a top end of the aisle 315, a temperature sensor 335 is located near a bleeding hole (or duct) 340. During normal operation, a temperature determined by temperature sensor 335 may lie between 18 and 30°C. In another embodiment, the temperature may lie between 22 and 26°C.

Another temperature sensor 345 is located near an intake of climate control unit 320. Here, the air warmed by the server cabinets may have a temperature around 32 to 38°C. Under certain conditions, the temperature may rise to values between 35 and 42°C.

Starting from normal operation, should equipment inside one of the server cabinets 305 and 310 dissipate more heat and therefore require more cooling, it will use internal fans to propel more cooling air per time from the aisle 315 through the server cabinet 305 or 310. By this, the pressure inside the aisle 315 with respect to the rest of the data centre will drop slightly. Consequently, an amount of warm air will be sucked through bleeding hole 340 towards the inside of the aisle 315. As this sucked-in air will pass at the temperature sensor 335, a temperature difference between the temperature determined by temperature sensor 335 and the temperature determined by sensor 325 can be determined. This may be interpreted as a requirement for more cooling air inside the aisle 315. Using a conveyor (not shown) integrated into climate control unit 320, more cool air per time is propelled through the duct 330. As there exists a regulation system that holds the temperature of the air coming out of the climate control unit 320 at a constant temperature, there is effectively more cool air per time available to the server cabinets 305 and 310. Therefore, the pressure difference between the aisle 315 and the rest of the data centre will no longer exist and no more warm air is sucked through the bleeding hole 340. Therefore the temperature that is registered by the temperature sensor 335 will drop back to a more normal value.

Similarly, should the devices located in the server cabinets 305 and 310 have less power to dissipate and will therefore convey less air from the aisle 315 through the server cabinets 305 and 310, the temperature registered by temperature sensor 335 will drop with respect to the temperature registered by temperature sensor 325. This may be interpreted as an excess of cold air inside the aisle 315, and propelling of cold air from the climate control unit 320 into the duct 330 may be decreased.

Ambient air temperature regulation of down flow units "traditional"

Existing regulations of down flow units are concentrated on ambience or return air regulation. That makes sense, if you are not using cold and hot aisle containment. If the airflow is not controlled the ambience air is hard to guarantee. So the best way to guaranty the ambience temperature for the IT- systems is to cool down the whole room on 22-26°C. The ambient or return air controls the cold water valve. The delivery air can have a temperature from 16-24°C depending on the return air temperature.

Delivery air temperature regulation of down flow units "new"

The idea of the new control strategy focuses on a controlled airflow to the cold aisle. Based on the fact, that the IT-systems take the cold air out of the cold aisle by themselves, heat the air up internally and blow the hot air in the hot aisle, it is not necessary to cool down the whole data centre room. That is the reason to change the control strategy form ambience and return air regulation to delivery air regulation.

Ambient temperature regulation of the cold aisle "new"

The basic idea is to deliver as much cold air to the cold aisle as the cold aisle demands. Sensors in the cold aisle measured the temperature on the top of the server racks. The temperature set point is two till five degrees higher than the delivery temperature set point. If the temperature on the top of the servers is lower than the set point, is this an indication that the down flow units deliver too much cold air to the cold aisle. If the temperature is higher than the set point, is this an indication that the down flow units deliver not enough cold air to the cold aisle. To control the cold air delivery to the cold aisles the fan speed has to be controlled by a regulation.

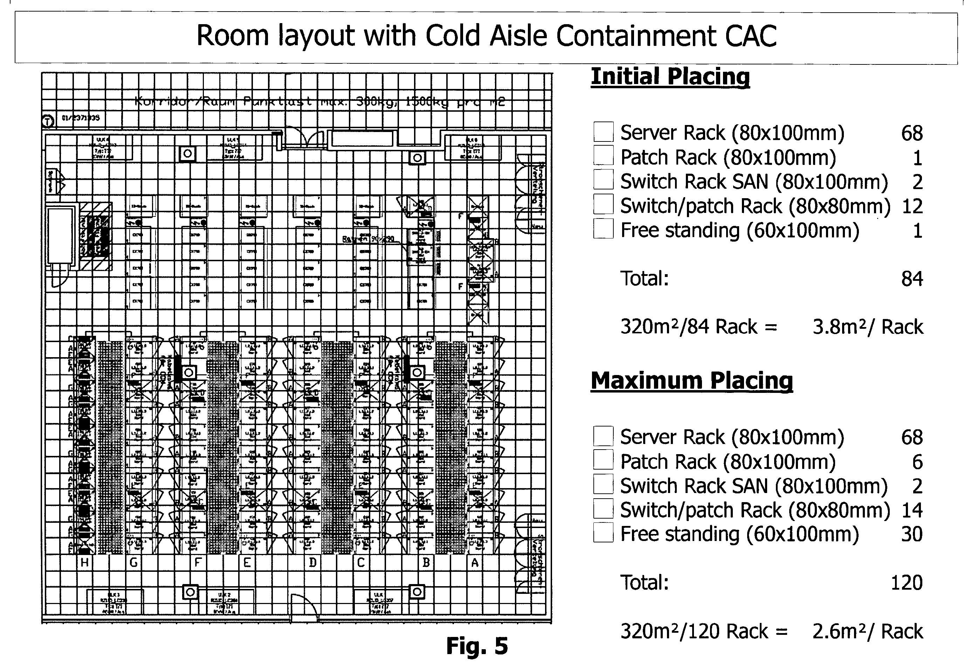

Referring to Fig. 5 once again, the basic setup of an exemplary data centre will now be discussed. The room will be cooled by six down flow units. A master regulation is responsible for the down flow unit management. The six down flow units are connected to the master as a slave. Each down flow unit is connected to two power distributions. To switch from one power unit to the other a manual switch has to be switched.

The six down flow units are connected to two different power supply systems. As long as both power supply systems are up, units 1, 3 and 5 are connected to the first power supply system and units 2, 4 and 6 are connected to the second power supply system. Should the first power supply system fail, units 1, 3 and 5 are switched to the second power supply system, so that all units are fed from the second power supply system. Vice versa, should the second power supply system fail, units 2, 4 and 6 are switched to the first power supply system, so that all units are fed by the first power supply system.

The communication to the down flow units has to be over a standard connection (Ethernet for example). All commands and items of information will be communicated over this communication. In case of communication failure all slaves have to react correctly to hold the temperature in the data centre room. Safety functions have to be implemented.

From the master control the following functions have to be implemented:
- Status of the down flow units (on / off / stand-by)
- Fan speed for the down flow units (30 - 100%) depend on the cold aisle temperature
- Set point of delivery air temperature
- Collection and visualisation of all information from the slave regulations

The following information elements will connect to the master control:
- Ambient air sensors (cold aisle) 16 piece
- Water leak detectors (6 piece)
- Down flow units (6 piece), all information and commands by bus (Ethernet)
- Measured data about electricity consumption of the Power distribution units

### 2.2.1 Automatic operating of the Master controller

The Master controller manages the status of every down flow unit in the data centre room. The statuses will be written to the slave. In case of a communication failure the last status will be saved.

A down flow unit can have the following statuses:
- ON: The down flow unit regulate the delivery air and the fan speed to the given (master control) set points.
- STAND-BY: The down flow unit is shut off. In case of failure of down flow unit, which is on the status ON, or in case of a communication failure the down flow units turn on. The delivery air temperature will be regulated by the "last known" set point. Fan speed run on default set point (100% adjustable).
- OFF: The down flow unit is shut off and will not turn on in case of any failure.

All commands, set point changes and information are visualised and controlled on a touch panel and on the BMS (Building Management System).

### 2.2.2 Fan speed regulation of the down flow units

The range of the fan speed set point of the down flow units can be between 30% and 100% and is adjustable from the control panel (minimum and maximum).

The demand of the fan speed is depending on the cold aisle temperature. The cold aisle temperature is measured twice per cold aisle on the top of the racks. The highest temperature in the cold aisles regulates the fan speed of all down flow units. The highest temperature in the cold aisle should be regulated (PI- controller) by the give set point (master control) of 24°C (adjustable on the master control and the BMS system). As soon the temperature in the cold aisle is lower than the set point the fan speed will be reduced till the temperature is back on the set point. Contrariwise if the temperature is higher than the set point.

All down flow units run parallel with the same fan speed.

### Safety functions

### Master failure

The master controller is connected to the UPS. In case of master failure (communication alert) the down flow units with the status "ON" run with maximum fan speed. The down flow units with the status "STAND-BY" turn on and run with maximum fan speed.

The monitoring and controlling from the BMS System is off line.
- The alarming T1ₑₗₑₖ go over GEIS and RMS
- Alarming T1ₑₗₑₖ will be visualised on the panel of the master control till acknowledgement.

### Water leak detection

Each down flow unit has a water leak detection. Alarming T1_{mech} will be produced. The down flow unit will not be shut off.
- The alarming T1ₑₗₑₖ go over GEIS and RMS
- Alarming T1ₑₗₑₖ will be visualised on the panel of the master control till acknowledgement.

### Cold aisle temperature monitoring

The cold aisle temperature is monitored by the air temperature sensors in the cold aisle. Is the temperature in the cold aisle rising over a given (master controller) first set point, the down flow units with the status "STAND-BY" will turn on.

Alarming T2_{mech} be visualised on the panel of the master control till acknowledgement.

A raise of the temperature in the cold aisle over a given (master controller) second set point an alarm T1_{mech} will be initiated.

### Alarming T1_{mech} go over GEIS and RMS

Alarming T1_{mech} will be visualised on the panel of the master control till acknowledgement.

### Status monitoring

The status of every down flow unit is monitored. Is the status of a down flow unit after 4 minutes not the same as from the master controller ordered, a down flow unit with the status "STAND-BY" will turned on and an alarm T1_{mech} will be initiated. The command to the failure down flow unit will not be taken back.

Alarming T2_{mech} be visualised on the panel of the master control till acknowledgement.

### Sensor monitoring

All sensors will be monitored. In case of failure an alarm T2ₑₗₑₖ will be initiated. No actions will be initiated. The failing sensor will be setting inactive.

Alarming T2_{mech} be visualised on the panel of the master control till acknowledgement.

### Fire detection system

The fire detection has no influence to the status of the down flow units.

### Visualisation

### Master panel

All information will be visualised in a touch panel. The status, set points and parameters of the master controller and the down flow units can be changed.

Control lights:
- Alarm T1_{mech} (rot)
- Alarm T1ₑₗₑₖ (rot)
- Nicht-Normal-Betrieb (weiß)
- Watchdog (rot)

There are no control lights on the down flow units.

Further Remarks regarding the previous embodiments:
- Increase the density in a Data Centre room by using CAC
   - Rack layout without cold and hot aisle / CAC = 0 - 500W/m2
   - Rack layout with cold and hot aisle = 0 - 1'000W/m2
   - Rack layout with cold aisle containment = 0 - 1'500W/m2
   (with CAC it may be possible to go even higher but we no tests yet)
- Raise the efficiency of the Down flow units by lowering the airflow. In a 300m² room with 1'000W/m² density we can avoid ∼ 36'000 CHF energy cost per year
   - This result is based on the higher efficiency of the DFU's
- Avoid "hot spots" and use the whole Rack space. Air volume in cold aisles can be best controlled in closed environments.
   - Multiple IT load in all cabinets possible (homogeneously distributed temperature and humidity)

### Advantages of CAC

- Easy installation or upgrade in all possible DC rooms with a minimum of raise floor high (30cm or one feet)
- No significant placing of DFU's in the DC rooms necessary
- Lower fan speed of the DFU's forced less noise in the DC rooms
- Homogeneously distributed temperature and humidity for all IT Systems
- Flexible placing of IT Systems in the cabinets
- All cabinets can be fully used (no ghost cabinets)
- Issues on the DFU have less impact (< 50% of the DFU's can be lost)
- Reduced running and energy cost of the DFU's
- Further saving possible by raising the cold water temperature on the chiller plant (increase longer terms of free cooling can be achieved)
- Increase the density in a Data Centre room by using CAC to find the maximum capacity of a rack.
   - Rack load of 03.6 kW (Footprint: 3.5 m² = 1'030 W/m²) = Passed!
   - Rack load of 07.2 kW (Footprint: 3.5 m² = 2'060 W/m²) = Passed!
   - Rack load of 10.8 kW (Footprint: 3.5 m² = 3'090 W/m²) = Passed!
   - Rack load of 14.4 kW (Footprint: 3.5 m² = 4'120 W/m²) = Passed!
   (Electrical distribution for more than 10kW per rack has to be defined)

With CAC it may be possible to go even higher but we couldn't find the limit with the installed test setup. The test installation was not capable to go over the 312kW or 4'120 W/m², with other words we were not in a position to demonstrate the limit of a cold aisle containment installation.
- Raise the efficiency of air handlers by lowering the airflow and reducing the air resistant.
   - Cheaper and more efficiency footplates in the cold zones reduce the air resistance.
   - A higher raised floor (600mm) allows more airflow by la lower air resistance.
- Including the communication equipment (switches and patch panes) into the cold aisle containment.
   - Reduce the unused airflow (front to back) with panels to a minimum.
   - Connect the communication switch (power supplies and panel fans) to the raised floor.

### Advantages of CAC

- Easy installation or upgrade in all possible DC rooms with a minimum of raise floor high (30cm or one feet)
- No significant placing of DFU's in the DC rooms necessary
- Lower fan speed of the DFU's is generating less noise in the DC rooms
- Homogeneously distributed temperature and humidity for all IT Systems
- Less restricted placing of IT Systems in the cabinets
- All cabinets can be fully used (no ghost cabinets) up to 10kW load, based on the electrical distribution
- Issues on the DFU have less impact (≤ 50% of the DFU's can be lost)
- Reduced running and energy cost of the DFU's
- Further saving possible by raising the cold water temperature on the chiller plant (longer periods of free cooling can be achieved)

**Different operating points for the same air handler (1/2)**

| | **L10UC** | | | | |
|---|---|---|---|---|---|
| Unit inlet air temperature | **24.0** | °C | Fluid | **WATER** | |
| Unit inlet air relative humidity | **45.0** | % | Inlet fluid temperature | **7.0** | °C |
| Unit airflow | **24000** | m³/ h | Outlet fluid temperature | **12.0** | °C |
| ESP | **20** | Pa | Unit fluid flow | **4.80** | Vs |
| Sea level | **0** | m | Unit power supply | **400 V/3 ph/50 Hz** | |

| | **Unit performances** | | | | |
|---|---|---|---|---|---|
| Unit | **L10UC** | | Unit power input | **6.24** | kW |
| Total cooling capacity | **100.5** | kW | Unit EER | **16.10** | |
| Sensible cooling capacity | **95.9** | kW | Internal filter class (EN779 std) | **G4** | |
| SHR | **0.95** | | Width | **2050** | mm |
| Off coil air temperature | **12.1** | °C | Depth | **890** | mm |
| Off coil air relative humidity | **92.1** | % | Height | **1950** | mm |
| Room SPL (@ 2m, f.f) | **63.1** | dB( A) | Weight | **630** | kg |

| | **CW** | **Coils** | | | |
|---|---|---|---|---|---|
| Quantity | **2** | n° | Fluid pressure drop coil+ connections | **47** | kPa |
| Unit fluid flow | **4.80** | l/s | Valve pressure drop | **19** | kPa |
| Unit fluid side pressure drop | **66** | kPa | | | |

| | **CW** | **Fans** | | | |
|---|---|---|---|---|---|
| Quantity | **2** | n° | Operating Ampere | **2 × 4.81** | A |
| Type | **Op-** | | Full load Ampere | **2 × 5.00** | A |
| | **tional** | | | | |
| Power supply | **400/3/** | | Locked rotor Ampere | **2 × 0.00** | A |
| | **50** | | | | |
| Power input | **2 ×** | kW | Fan input voltage | **10.0** | V |
| | **3.12** | | | | |

This is the dimension of the air handlers with the **Vendor set-up** → **100 kW per Unit**

**Different operating points for the same air handler (2/2)**

| | **L10UC** | | | | |
|---|---|---|---|---|---|
| Unit inlet air temperature | **25.0** | °C | Fluid | **WATER** | |
| Unit inlet air relative humidity | **45.0** | % | Inlet fluid temperature | **13.0** | °C |
| Unit airflow | **18000** | m³/ h | Outlet fluid temperature | **18.0** | °C |
| ESP | **20** | Pa | Unit fluid flow | **2,47** | Vs |
| Sea level | **0** | m | Unit power supply | **400 V/3 ph/50 Hz** | |

| | **Unit performances** | | | | |
|---|---|---|---|---|---|
| Unit | **L10UC** | | Unit power input | **2.64** | kW |
| Total cooling capacity | **51.6** | kW | Unit EER | **19.60** | |
| Sensible cooling capacity | **51.6** | kW | Internal filter class (EN779 std) | **G4** | |
| SHR | **1.00** | | Width | **2050** | mm |
| Off coil air temperature | **16.4** | °C | Depth | **890** | mm |
| Off coil air relative humidity | **75.7** | % | Height | **1950** | mm |
| Room SPL (@ 2m, f.f) | **57.0** | dB( A) | Weight | **630** | kg |

| | **CW** | **Coils** | | | |
|---|---|---|---|---|---|
| Quantity | **2** | n° | Fluid pressure drop coil+ connections | **14** | kPa |
| Unit fluid flow | **2.47** | l/s | Valve pressure drop | **5** | kPa |
| Unit fluid side pressure drop | **19** | kPa | | | |

| | **CW** | **Fans** | | | |
|---|---|---|---|---|---|
| Quantity | **2** | n° | Operating Ampere | **2 × 4.81** | A |
| Type | **Op-** | | Full load Ampere | **2 × 5.00** | A |
| | **tional** | | | | |
| Power supply | **400/3/** | | Locked rotor Ampere | **2 × 0.00** | A |
| | **50** | | | | |
| Power input | **2 x** | kW | Fan input voltage | **7.5** | V |
| | **1.32** | | | | |

This is the dimension of the air handlers with the **sold USB set-up** → **50 kW per Unit**

**Different operating points for the same air handler (1/2)**

| | **L10UC** | | | | |
|---|---|---|---|---|---|
| Unit inlet air temperature | **30.0** | °C | Fluid | **WATER** | |
| Unit inlet air relative humidity | **40.0** | % | Inlet fluid temperature | **13.0** | °C |
| Unit airflow | **12400** | m³/ h | Outlet fluid temperature | **18.0** | °C |
| ESP | **20** | Pa | Unit fluid flow | **2.74** | Vs |
| Sea level | **0** | m | Unit power supply | **400 V/3 ph/50 Hz** | |

| | **Unit performances** | | | | |
|---|---|---|---|---|---|
| Unit | **L10UC** | | Unit power input | **1.04** | kW |
| Total cooling capacity | **57.3** | kW | Unit EER | **55.10** | |
| Sensible cooling capacity | **57.3** | kW | Internal filter class (EN779 std) | **G4** | |
| SHR | **1.00** | | Width | **2050** | mm |
| Off coil air temperature | **16.0** | °C | Depth | **890** | mm |
| Off coil air relative humidity | **93.0** | % | Height | **1950** | mm |
| Room SPL (@ 2m, f.f) | **50.1** | dB( A) | Weight | **630** | kg |

| | **CW** | **Coils** | | | |
|---|---|---|---|---|---|
| Quantity | **2** | n° | Fluid pressure drop coil+ connections | **17** | kPa |
| Unit fluid flow | **4.80** | l/s | Valve pressure drop | **6** | kPa |
| Unit fluid side pressure drop | **66** | kPa | | | |

| | **CW** | **Fans** | | | |
|---|---|---|---|---|---|
| Quantity | **2** | n° | Operating Ampere | **2 × 0.80** | A |
| Type | **Op-** | | Full load Ampere | **2 × 5.00** | A |
| | **tional** | | | | |
| Power supply | **400/3/** | | Locked rotor Ampere | **2 × 0.00** | A |
| | **50** | | | | |
| Power input | **2 ×** | kW | Fan input voltage | **5.5** | V |
| | **0.52** | | | | |

This is the dimension of the air handlers we can use very efficiently under **normal conditions** → **50 kW per Unit**

The calculation tool is limited to a maximum unit inlet air temperature < 30°C and minimum unit airflow < 12'400 m³/h further Improvement possible and tested

**Different operating points for the same air handler (2/2)**

| | **L10UC** | | | | |
|---|---|---|---|---|---|
| Unit inlet air temperature | **30.0** | °C | Fluid | **WATER** | |
| Unit inlet air relative humidity | **40.0** | % | Inlet fluid temperature | **13.0** | °C |
| Unit airflow | **24000** | m³/ h | Outlet fluid temperature | **18.0** | °C |
| ESP | **20** | Pa | Unit fluid flow | **4.74** | Vs |
| Sea level | **0** | m | Unit power supply | **400 V/3 ph/50** Hz | |

| | **Unit performances** | | | | |
|---|---|---|---|---|---|
| Unit | **L10UC** | | Unit power input | **6.24** | kW |
| Total cooling capacity | **99.2** | kW | Unit EER | **15.90** | |
| Sensible cooling capacity | **99.2** | kW | Internal filter class (EN779 std) | **G4** | |
| SHR | **1.00** | | Width | **2050** | mm |
| Off coil air temperature | **17.4** | °C | Depth | **890** | mm |
| Off coil air relative humidity | **84.3** | % | Height | **1950** | mm |
| Room SPL (@ 2m, f.f) | **63.1** | dB( A) | Weight | **630** | kg |

| | **CW** | **Coils** | | | |
|---|---|---|---|---|---|
| Quantity | **2** | n° | Fluid pressure drop coil+ connections | **44** | kPa |
| Unit fluid flow | **4.74** | l/s | Valve pressure drop | **19** | kPa |
| Unit fluid side pressure drop | **63** | kPa | | | |

| | **CW** | **Fans** | | | |
|---|---|---|---|---|---|
| Quantity | **2** | n° | Operating Ampere | **2 x 4.81** | A |
| Type | **Op-** | | Full load Ampere | **2 x 5.00** | A |
| | **tional** | | | | |
| Power supply | **400/3/** | | Locked rotor Ampere | **2 x 0.00** | A |
| | **50** | | | | |
| Power input | **2 x** | kW | Fan input voltage | **10.0** | V |
| | **3.12** | | | | |

This is the dimension of the air handlers we can use very efficiently under **normal conditions** → **50 kW per Unit**
The calculation tool is limited to a maximum unit inlet air temperature < 30°C and minimum unit airflow < 12'400 m³/h further Improvement possible and tested

## Claims

1. A device for controlling climate parameters of a plurality of racks (305, 310) arranged such as to form at least one aisle (315) between them and so that for each of the at least one aisle, one of supply sides and removal sides of all racks adjacent to the aisle face towards the aisle, wherein at least one cover element seals the aisle at a top end, the cover element comprising a bleeding opening, and wherein ends of the aisle are closed by at least one of racks and termination elements, the device being **characterized by**
- at least one sensor (335; 345) adapted to determine a direction of medium flow at the bleeding opening (340) arranged for bleeding the medium from or into the aisle so that the direction is indicative of excess of air inside the aisle or a pressure drop inside the aisle, wherein the medium is air; and
- a control unit connected to the at least one sensor and adapted to control performance of a conveyor conveying the medium along a path along which the medium is exchanged between a climate control unit (320) and the plurality of racks.

2. The device of claim 1, wherein the racks have the supply side for supplying medium to the racks and the removal side for removing medium from the racks, and wherein the control unit is further adapted to increase the performance of the conveyor, if a medium flow from the removal side to the supply side is determined.

3. The device of claim 2, wherein the control unit is further adapted to decrease the performance of the conveyor, if the medium flow is no longer detected.

4. The device of one of the previous claims, wherein the performance of the conveyor is controlled in correspondence to a change in temperature difference between two points along the path.

5. The device of one of the previous claims, wherein the at least one sensor comprises an airscrew, which turns in a direction according to the direction of the medium flowing through it.

6. The device of one of claims 1 to 4, wherein the at least one sensor comprises a switch that is attached to a sail, which catches some media and turns into a direction dependent on the direction of flow of the medium.

7. The device of one of claims 1 to 4, wherein the at least one sensor is adapted to compare properties of the medium on both ends of the bleeding opening.

8. The device of claim 7, wherein the property compared by the at least one sensor is a temperature or a pressure of the medium.

9. The device of one of the previous claims, wherein all of the supply sides face the aisle and all of the removal sides are on those sides of the racks that face away from the aisle.

10. The device of one of the previous claims, wherein all of the removal sides face the aisle and all of the supply sides face away from the aisle.

11. The device of one of the previous claims, wherein the at least one sealing element comprises a termination element at one or more ends of the aisle to seal the aisle.

12. The device of one of the previous claims, wherein at least one of the plurality of racks comprises a plurality of mounting spaces for accommodating payload, and wherein the at least one sealing element is adapted to seal the mounting spaces that are not occupied by payload towards the aisle.

13. The device of one of the previous claims, wherein the climate control unit is adapted to control the climate parameters of the medium and the control unit is further adapted to control performance of the climate control unit.

14. The device of one of the previous claims, wherein at least one of the plurality of racks comprises a plurality of mounting spaces for accommodating payload, and wherein the payload comprises a private medium conveyor for conveying medium from a supply side to a removal side of the at least one rack.

15. A method of controlling climate parameters of a plurality of racks (305, 310) arranged such as to form at least one aisle (315) between them and so that for each of the at least one aisle, one of the supply sides and the removal sides of all racks adjacent to the aisle face towards the aisle, wherein at least one cover element seals the aisle at a top end, the cover element comprising a bleeding opening, and wherein ends of the aisle are closed by at least one of racks and termination elements, the method being **characterized by**
- determining, using at least one sensor (335; 345), a direction of medium flow at the bleeding opening (340) arranged for bleeding the medium from or into the aisle so that the direction is indicative of excess of air inside the aisle or a pressure drop inside the aisle, respectively, wherein the medium is air; and
- controlling, based on the determination, performance of a conveyor conveying the medium along a path along which the medium is exchanged between a climate control unit (320) and the plurality of racks.

16. The method of claim 15, wherein the controlling includes increasing the performance of the conveyor, if a medium flow from a removal side for removing medium from the racks to a supply side for supplying medium to the racks is determined.

17. The method of claim 16, wherein the controlling further includes decreasing the performance of the conveyor, if the medium flow is no longer detected.

18. The method of one of claims 15 to 17, wherein the determination includes comparing properties of the medium on both ends of the bleeding opening.

19. The method of claim 18, wherein the compared property is a temperature or a pressure of the medium.

## Patentansprüche

1. Vorrichtung zum Steuern von Klimaparametern einer Vielzahl an Racks (305, 310), die so angeordnet sind, dass sie wenigstens einen Gang (315) zwischen sich bilden und dass für jeden wenigstens einen Gang entweder Zuführungsseiten oder Abführungsseiten aller an den Gang angrenzenden Racks zum Gang hin ausgerichtet sind, wobei wenigstens ein Abdeckungselement den Gang an einem oberen Ende abdichtet, wobei das Abdeckungselement eine Entlüftungsöffnung umfasst und wobei Enden des Gangs durch Racks und/oder Abschlusselemente verschlossen sind, wobei die Vorrichtung **gekennzeichnet ist durch**
- wenigstens einen Sensor (335; 345), der ausgebildet ist zum Bestimmen einer Richtung eines Stroms eines Mediums an der zum Entlüften des Mediums von dem oder in den Gang angeordneten Entlüftungsöffnung (340), so dass die Richtung auf einen Überschuss von Luft innerhalb des Gangs oder auf einen Druckabfall innerhalb des Gangs hinweist, wobei das Medium Luft ist; und
- eine mit dem wenigstens einen Sensor verbundene Steuereinheit, die ausgebildet ist zum Steuern einer Leistung eines Fördermittels zum Fördern des Mediums entlang eines Pfads, entlang welchem das Medium zwischen einer Klimasteuereinheit (320) und der Vielzahl an Racks ausgetauscht wird.

2. Vorrichtung nach Anspruch 1, wobei die Racks die Zuführseite zum Zuführen des Mediums zu den Racks und die Abführungsseite zum Abführen des Medium von den Racks aufweisen und wobei die Steuereinheit weiter ausgebildet ist zum Erhöhen der Leistung des Fördermittels, wenn ein Strom eines Mediums von der Abführungsseite zu der Zuführungsseite bestimmt wird.

3. Vorrichtung nach Anspruch 2, wobei die Steuereinheit weiter ausgebildet ist zum Verringern der Leistung des Fördermittels, wenn der Strom des Mediums nicht länger erfasst wird.

4. Verfahren nach einem der vorherigen Ansprüche, wobei die Leistung des Fördermittels in Übereinstimmung mit einer Änderung einer Temperaturdifferenz zwischen zwei Punkten entlang des Pfads gesteuert wird.

5. Vorrichtung nach einem der vorherigen Ansprüche, wobei der wenigstens eine Sensor einen Propeller umfasst, welcher sich in eine Richtung entsprechend der Strömungsrichtung des Mediums durch diesen dreht.

6. Vorrichtung nach einem der Ansprüche 1 bis 4, wobei der wenigstens eine Sensor einen an einem Segel angebrachten Schalter umfasst, das etwas Medium fängt und sich in Abhängigkeit von der Strömungsrichtung des Mediums dreht.

7. Vorrichtung nach einem der Ansprüche 1 bis 4, wobei der wenigstens eine Sensor ausgebildet ist zum Vergleichen von Eigenschaften des Mediums an beiden Enden der Entlüftungsöffnung.

8. Vorrichtung nach Anspruch 7, wobei die durch den wenigstens einen Sensor verglichene Eigenschaft eine Temperatur oder ein Druck des Mediums ist.

9. Vorrichtung nach einem der vorherigen Ansprüche, wobei alle Zuführungsseiten zum Gang hin ausgerichtet sind und alle Abführungsseiten an denjenigen Seiten der Racks sind, die von dem Gang weg gerichtet sind.

10. Vorrichtung nach einem der vorherigen Ansprüche, wobei alle Abführungsseiten zu dem Gang hin ausgerichtet sind und alle Zuführungsseiten von dem Gang weg gerichtet sind.

11. Vorrichtung nach einem der vorherigen Ansprüche, wobei das wenigstens eine Abdichtungselement ein Abschlusselement an einem oder mehreren Enden des Gangs zum Abdichten des Gangs umfasst.

12. Vorrichtung nach einem der vorherigen Ansprüche, wobei wenigstens eines der Vielzahl an Racks eine Vielzahl an Einbauräumen zur Aufnahme von Nutzlast umfasst und wobei das wenigstens eine Abdichtungselement ausgebildet ist zum Abdichten der Einbauräume, die nicht durch eine Nutzlast belegt sind, zum Gang hin.

13. Vorrichtung nach einem der vorherigen Ansprüche, wobei die Klimasteuerungseinheit ausgebildet ist zum Steuern der Klimaparameter des Mediums und die Steuereinheit weiter ausgebildet ist zum Steuern einer Leistung der Klimasteuerungseinheit.

14. Vorrichtung nach einem der vorherigen Ansprüche, wobei wenigstens eines der Vielzahl an Racks eine Vielzahl an Einbauräumen zur Aufnahme von Nutzlast umfasst und wobei die Nutzlast ein eigenes Medium-Fördermittel zum Fördern des Mediums von der Zuführungsseite zu der Abführungsseite des wenigstens einen Racks umfasst.

15. Verfahren zum Steuern von Klimaparametern einer Vielzahl an Racks (305, 310), die so angeordnet sind, dass sie wenigstens einen Gang (315) zwischen sich bilden, und so, dass für jeden wenigstens einen Gang entweder die Zuführungsseiten oder die Abführungsseiten aller an den Gang angrenzenden Racks zum Gang hin ausgerichtet sind, wobei wenigstens ein Abdeckungselement den Gang an einem oberen Ende abdichtet, wobei das Abdeckungselement eine Entlüftungsöffnung umfasst und wobei Enden des Gangs durch Racks und/oder Abschlusselemente geschlossen sind, wobei das Verfahren **gekennzeichnet ist durch**
- Bestimmen, **durch** Verwenden wenigstens eines Sensors (335; 345), einer Richtung eines Stroms eines Mediums an der zum Entlüften des Mediums von dem oder in den Gang angeordneten Entlüftungsöffnung (340), so dass die Richtung entsprechend auf einen Überschuss von Luft innerhalb des Gangs oder einen Druckabfall innerhalb des Gangs hinweist, wobei das Medium Luft ist; und
- Steuern, basierend auf dem Bestimmen, einer Leistung eines Fördermittels zum Fördern des Mediums entlang eines Pfads, entlang welchem das Medium zwischen einer Klimasteuereinheit (320) und der Vielzahl an Racks ausgetauscht wird.

16. Verfahren nach Anspruch 15, wobei das Steuern ein Erhöhen der Leistung des Fördermittels beinhaltet, wenn ein Strom eines Mediums von einer Abführungsseite zum Abführen des Mediums von den Racks zu einer Zuführungsseite zum Zuführen des Mediums zu dem Rack bestimmt wird.

17. Verfahren nach Anspruch 16, wobei das Steuern weiter ein Verringern der Leistung des Fördermittels beinhaltet, wenn der Strom des Mediums nicht länger erfasst wird.

18. Verfahren nach einem der Ansprüche 15 bis 17, wobei das Bestimmen ein Vergleichen von Eigenschaften des Mediums an beiden Enden der Entlüftungsöffnung umfasst.

19. Verfahren nach Anspruch 18, wobei die verglichene Eigenschaft eine Temperatur oder ein Druck des Mediums ist.

## Revendications

1. Dispositif de régulation de paramètres climatiques d'une pluralité de bâtis (305, 310) agencés de manière à former au moins une allée (315) entre eux, et de sorte que pour chacune de l'au moins une allée, un des côtés de délivrance et des côtés d'évacuation de tous les bâtis adjacents à l'allée font face à l'allée, dans lequel au moins un élément de couvercle ferme de manière étanche l'allée au niveau d'une extrémité supérieure, l'élément de couvercle comprenant une ouverture d'écoulement, et dans lequel des extrémités de l'allée sont fermées par au moins un des bâtis et des éléments de terminaison, le dispositif étant **caractérisé par** :
- au moins un capteur (335 ; 345) adapté pour déterminer une direction d'un flux du milieu au niveau de l'ouverture d'écoulement (340) disposée pour écouler le milieu depuis l'allée, ou dans celle-ci, de sorte que la direction indique un excès d'air à l'intérieur de l'allée ou une baisse de pression à l'intérieur de l'allée, dans lequel le support est l'air ; et
- une unité de régulation connectée à l'au moins un capteur et adaptée pour réguler la performance d'un convecteur qui convoie le milieu le long d'un chemin le long duquel le milieu est échangé entre une unité de régulation climatique (320) et la pluralité de bâtis.

2. Dispositif selon la revendication 1, dans lequel les bâtis disposent du côté de délivrance pour délivrer le milieu vers les bâtis et du côté d'évacuation pour évacuer le milieu des bâtis, et dans lequel l'unité de régulation est adaptée en outre pour augmenter la performance du convecteur, si un flux de milieu est déterminé depuis le côté d'évacuation vers le côté de délivrance.

3. Dispositif selon la revendication 2, dans lequel l'unité de régulation est adaptée en outre pour diminuer la performance du convecteur, si le flux du milieu n'est plus détecté.

4. Dispositif selon l'une des revendications précédentes, dans lequel la performance du convecteur est régulée en fonction d'un changement de différence de température entre deux points le long du chemin.

5. Dispositif selon l'une des revendications précédentes, dans lequel l'au moins un capteur comprend une hélice, qui tourne dans une direction en fonction de la direction du milieu qui la traverse.

6. Dispositif selon l'une des revendications 1 à 4, dans lequel l'au moins un capteur comprend un commutateur qui est fixé à une voile, qui recueille certains supports et se tourne dans une direction en fonction de la direction du flux du milieu.

7. Dispositif selon l'une des revendications 1 à 4, dans lequel l'au moins un capteur est adapté pour comparer des propriétés du milieu sur les deux extrémités de l'ouverture d'écoulement.

8. Dispositif selon la revendication 7, dans lequel la propriété comparée par l'au moins un capteur est une température ou une pression du milieu.

9. Dispositif selon l'une des revendications précédentes, dans lequel la totalité des côtés de délivrance font face à l'allée et la totalité des côtés d'évacuation sont sur les côtés des bâtis qui font face à l'opposé de l'allée.

10. Dispositif selon l'une des revendications précédentes, dans lequel la totalité des côtés d'évacuation font face à l'allée et la totalité des côtés de délivrance font face à l'opposé de l'allée.

11. Dispositif selon l'une des revendications précédentes, dans lequel l'au moins un élément d'étanchéité comprend un élément de terminaison au niveau d'une ou de plusieurs extrémités de l'allée adapté pour fermer l'allée de manière étanche.

12. Dispositif selon l'une des revendications précédentes, dans lequel au moins un de la pluralité de bâtis comprend une pluralité d'espaces de montage permettant de loger une charge utile, et dans lequel l'au moins un élément d'étanchéité est adapté pour fermer de manière étanche les espaces de montage qui ne sont pas occupés par la charge utile vers l'allée.

13. Dispositif selon l'une des revendications précédentes, dans lequel l'unité de régulation de climat est adaptée pour réguler les paramètres climatiques du milieu et l'unité de régulation est adaptée en outre pour réguler la performance de l'unité de régulation de climat.

14. Dispositif selon l'une des revendications précédentes, dans lequel au moins un de la pluralité de bâtis comprend une pluralité d'espaces de montage permettant de loger la charge utile, et dans lequel la charge utile comprend un convecteur de milieu privé permettant de convoyer un milieu depuis un côté de délivrance vers un côté d'évacuation de l'au moins un bâti.

15. Procédé de régulation de paramètres climatiques d'une pluralité de bâtis (305, 310) agencés de manière à former au moins une allée (315) entre eux, et de sorte que pour chacune de l'au moins une allée, un des côtés de délivrance et des côtés d'évacuation de tous les bâtis adjacents à l'allée font face à l'allée, dans lequel au moins un élément de couvercle ferme de manière étanche l'allée au niveau d'une extrémité supérieure, l'élément de couvercle comprenant une ouverture d'écoulement, et dans lequel des extrémités de l'allée sont fermées par au moins un des bâtis et des éléments de terminaison, le procédé étant **caractérisé par** :
- la détermination, à l'aide d'au moins un capteur (335 ; 345), d'une direction de flux du milieu au niveau de l'ouverture d'écoulement (340) disposée pour écouler le milieu depuis l'allée, ou dans celle-ci, de sorte que la direction indique un excès d'air à l'intérieur de l'allée ou une baisse de pression à l'intérieur de l'allée, respectivement, dans lequel le support est l'air ; et
- la régulation, sur la base de la détermination, de la performance d'un convecteur qui convoie le milieu le long d'un chemin le long duquel le milieu est échangé entre une unité de régulation climatique (320) et la pluralité de bâtis.

16. Système selon la revendication 15, dans lequel la régulation consiste à augmenter la performance du convecteur, si un flux de milieu provenant d'un côté d'évacuation pour évacuer le milieu des bâtis vers un côté de délivrance pour délivrer le milieu aux bâtis est déterminé.

17. Procédé selon la revendication 16, dans lequel la régulation consiste en outre à diminuer la performance du convecteur, si le flux du milieu n'est plus détecté.

18. Procédé selon l'une des revendications 15 à 17, dans lequel la détermination consiste à comparer des propriétés du milieu sur les deux extrémités de l'ouverture d'écoulement.

19. Procédé selon la revendication 18, dans lequel la propriété comparée est une température ou une pression du milieu.
